# EUROPÄISCHE PATENTSCHRIFT

(11) **EP 1 968 365 B1**
(45) Veröffentlichungstag und Bekanntmachung des Hinweises auf die Patenterteilung: **27.05.2009**
(21) Anmeldenummer: 07004735.2
(22) Anmeldetag: 08.03.2007
(51) Int. Cl.: H05K 3/30

(54) **Leiterplatte mit einem winkelförmigen Stanzgitter bestückt**
PCB equipped with an angled lead frame
Plaquette munie d'un socle angulé

(43) Veröffentlichungstag der Anmeldung: 10.09.2008
(73) Patentinhaber: Delphi Technologies, Inc., Troy, Michigan 48007 (US)
(72) Erfinder: Groben, Manfred, 55599 Gau-Bickelheim (DE); Leng, Peter, 55128 Mainz (DE)
(74) Vertreter: Denton, Michael John

(56) Entgegenhaltungen:
- EP-A- 1 345 274
- EP-A- 1 524 892
- WO-A-00/77526
- JP-A- 2001 053 294
- US-A1- 2004 008 519

## Beschreibung

Die Erfindung bezieht sich auf eine Leiterplatte, die mit einem dreidimensional ausgeformten Stanzgitter bestückt ist, das mehrere teilweise mit Kunststoff umspritzte Strompfade umfasst, und mindestens einem elektrischen oder elektronischen Bauteil.

Die DE 38 21 121 A1 beschreibt ein Verfahren zur Herstellung eines Kontaktträgerkörpers, der mit elektrisch leitenden Verbindungsbahnen und mit starren Kontaktteilen, wie Kontaktfedern, Lampenfassungen und dgl., versehen ist. Zunächst werden die starren Kontaktteile mechanisch an der Kontaktträgerplatte durch Einlegen oder Verrasten angebracht, wozu Anformungen oder Öffnungen im Bereich der Befestigungsstellen angeordnet sind, und anschließend wird eine pastenförmige oder flüssige Kontaktmasse zur Bildung der elektrisch leitenden Verbindungsbahnen aufgebracht. Durch das beschriebene Verfahren soll die nachteilige Verwendung von Leiterplatten und Stanzgittern vermieden werden.

Im Weiteren zeigt die DE 10 2005 006 819 A1 eine Leiterplatte mit einer Leuchtdiode in SMD-Technik, deren Anschlusskontakte auf der Oberseite des Bauteils verlötet sind. Um eine Wärmeabfuhr im Betrieb der Leuchtdiode zu ermöglichen, ist die Leiterplatte im Bereich der Leuchtdiode mit einer Vielzahl von Durchkontaktierungen versehen. Als problematisch erweist es sich, wenn das Bauteil in eine bestimmte Richtung weisen muss, da es bei einer gerichteten Verwendung in der Regel erforderlich ist, die Leiterplatte in einer entsprechenden Einbaulage zu montieren, was einen relativ großen Einbauraum erfordert. Darüber hinaus ist durch die Durchkontaktierungen nur eine beschränkte Wärmeabfuhr von der Leuchtdiode gegeben.

Diesen Stand der Technik beinhaltet auch das Dokument EP-A2-1 345 274.

Es ist Aufgabe der Erfindung, eine Leiterplatte der eingangs genannten Art zu schaffen, an der ein Bauteil in einer zur Oberfläche der Leiterplatte abweichenden definierten Richtung zu befestigen und eine zuverlässige Wärmeabfuhr gewährleistet ist.

Erfindungsgemäß wird die Aufgabe dadurch gelöst, dass eine Leiterplatte gemäß Anspruch 1 beschaffen wird, wobei das Stanzgitter winkelförmig ausgebildet ist, und wobei freie Stirnseiten der sich über die Schenkel erstreckenden Strompfade des Stanzgitters die Leiterplatte kontaktieren und zwischen den Strompfaden das Bauteil in einer definierten Ausrichtung angeordnet ist.

Über das Stanzgitter, dessen das Bauteil halternde und elektrisch kontaktierende Schenkel zu der Leiterplatte beabstandet sind, ist eine einwandfreie Wärmeabfuhr von dem Bauteil sichergestellt, ohne dass an der Leiterplatte spezielle wärmetechnische Maßnahmen getroffen werden müssen.

Im Weiteren fixiert das winkelförmige, also dachförmige Stanzgitter das Bauteil in einer definierten, von der Oberfläche der Leiterplatte abweichenden Lage. Damit ist eine Platz sparende Montage möglich.

Bevorzugt weist zumindest einer der Schenkel des Stanzgitters eine gegenüber dem anderen Schenkel vergrößerte Oberfläche aufweist. Die aus Metall bestehenden Schenkel dienen mit ihren Strompfaden sowohl als Stromleiter als auch zur Wärmeleitung bzw. -übertragung. Der relativ große Schenkel des Stanzgitters bewirkt einen verhältnismäßig schnellen Wärmetransport.

Zweckmäßigerweise ist das die Strompfade kontaktierende Bauteil ein Sensor, insbesondere ein Hall-Sensor, oder ein Leuchtmittel. Um ausgesandte Lichtstrahlen zu bündeln, ist vorzugsweise dem als Leuchtdiode ausgebildeten Leuchtmittel ein auf dem Stanzgitter angeordneter Reflektor zugeordnet. Alternativ oder zusätzlich zu dem Reflektor ist der Leuchtdiode ein Lichtleiter zugeordnet.

In Ausgestaltung ist der mit der Leuchtdiode versehene Schenkel des Stanzgitters parallel zu einer Lichtaustrittsfläche einer Streuscheibe einer Leuchte, insbesondere einer Innenleuchte eines Kraftfahrzeugs, ausgerichtet. Demnach sendet die Leuchtdiode eine Strahlung in Richtung der Streuscheibe, durch die beispielsweise ein Aufnahmeraum für die Leuchtdiode bereitgestellt wird, während die Leiterplatte in einem relativ kleinen Gehäuse unterzubringen ist. Die Leiterplatte kann bei Verwendung in einer Innenleuchte einen Kraftfahrzeuges, die in Richtung eines Fahrers und eines Beifahrers oder nach vorn und hinten Licht emittieren soll, zwei Leuchtdioden umfassen, die auf gegenläufig ausgerichteten Schenkeln von zwei beabstandet zueinander auf der Leiterplatte angeordneten Stanzgittern befestigt sind.

Zweckmäßigerweise sind das Stanzgitter und/oder das Bauteil als SMD-Bauteil ausgebildet und die Strompfade des Stanzgitters kontaktieren die Oberseite der Leiterplatte. Somit ist die Leiterplatte mit eng zueinander beabstandeten Bauelementen zu bestücken und bei einem kompakten Aufbau kostengünstig herzustellen.

Es versteht sich, dass die vorstehend genannten und nachstehend noch zu erläuternden Merkmale nicht nur in der jeweils angegebenen Kombination, sondern auch in anderen Kombinationen verwendbar sind. Der Rahmen der Erfindung ist nur durch die Ansprüche definiert.

Die Erfindung wird im Folgenden anhand eines Ausführungsbeispieles unter Bezugnahme auf die zugehörigen Zeichnungen näher erläutert. Es zeigt:

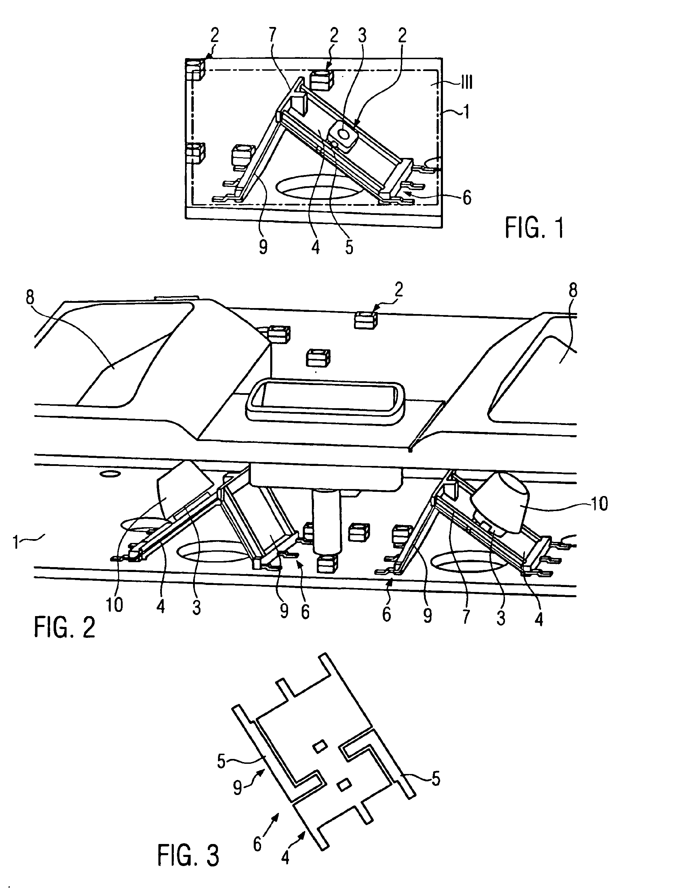

- Fig.1: eine perspektivische Teildarstellung einer erfindungsgemäßen Leiterplatte,
- Fig.2: eine weitere Teildarstellung der Leiterplatte nach Fig. 1 und
- Fig.3: eine Darstellung einer Abwicklung eines Stanzgitters gemäß der Einzelheit III nach Fig. 1.

Die Leiterplatte 1 ist ein Teil einer Innenraumleuchte eines Kraftfahrzeuges und trägt mehrere in SMD-Technik angeordnete elektronische Bauteile 2, von denen zwei als Leuchtdioden 3 ausgebildet sind. Jede Leuchtdiode 3 ist auf einem Schenkel 4 eines mehrere Strompfade 5 umfassenden, winkelförmig gebogenen Stanzgitters 6 befestigt, wobei die Strompfade in einen die Strompfade 5 gegenseitig isolierenden Kunststoff 7 eingebettet sind und an den freien Stirnseiten des Stanzgitters 6, die auf der Leiterplatte 1 aufliegen, die Leiterplatte 1 elektrisch kontaktieren. Durch die Formgebung des Stanzgitters 6 nimmt die Leuchtdiode 3 eine definierte Richtung sowohl zu der Leiterplatte 1 als auch zu einer Streuscheibe 8 der Innenraumleuchte ein und es ist mit einfachen Mitteln möglich, zwei in unterschiedliche Richtungen strahlende Leuchtdioden 3 einer ebenen Leiterplatte 1 zuzuordnen. Im Weiteren stellt das Stanzgitter 6 insbesondere über den nicht mit der Leuchtdiode 3 bestückten Schenkel 9, der großflächiger als der die Leuchtdiode 3 tragende Schenkel 4 dimensioniert ist, eine Ableitung der Wärme sicher, die im Betrieb der Leuchtdiode 3 unweigerlich entsteht. Um eine gezielte Lichtstrahlenbündelung in Richtung der Streuscheibe 8 zu bewirken, ist der Leuchtdiode ein an dem Stanzgitter 6 befestigter Reflektor 10 zugeordnet.

## Patentansprüche

1. Leiterplatte mit einem dreidimensional ausgeformten Stanzgitter (6), das mehrere teilweise mit Kunststoff (7) umspritzte Strompfade (5) umfasst, und mindestens einem elektrischen oder elektronischen Bauteil (2) bestückt, **dadurch gekennzeichnet, dass** das Stanzgitter (6) winkelförmig ausgebildet ist, wobei freie Stirnseiten der sich über die Schenkel (4, 9) erstreckenden Strompfade (5) des Stanzgitters (6) die Leiterplatte (1) kontaktieren und zwischen den Strompfaden (5) das Bauteil (2) in einer definierten Ausrichtung angeordnet ist.

2. Leiterplatte nach Anspruch 1, **dadurch gekennzeichnet, dass** zumindest einer der Schenkel (9) des Stanzgitters (6) eine gegenüber dem anderen Schenkel (4) vergrößerte Oberfläche aufweist.

3. Leiterplatte nach Anspruch 1 oder 2, **dadurch gekennzeichnet, dass** das die Strompfade (5) kontaktierende Bauteil (2) ein Sensor, insbesondere ein Hall-Sensor, oder ein Leuchtmittel ist.

4. Leiterplatte nach Anspruch 3, **dadurch gekennzeichnet, dass** dem als Leuchtdiode (3) ausgebildeten Leuchtmittel ein auf dem Stanzgitter (6) angeordneter Reflektor (10) zugeordnet ist.

5. Leiterplatte nach Anspruch 3, **dadurch gekennzeichnet, dass** dem als Leuchtdiode (3) ausgebildeten Leuchtmittel ein Lichtleiter zugeordnet ist.

6. Leiterplatte nach einem der Ansprüche 3 bis 5, **dadurch gekennzeichnet, dass** der mit dem als Leuchtdiode ausgebildete Leuchtmittel (3) versehene Schenkel (4) des Stanzgitters (6) parallel zu einer Lichtaustrittsfläche einer Streuscheibe (8) einer Leuchte, insbesondere einer Innenleuchte eines Kraftfahrzeugs, ausgerichtet ist.

7. Leiterplatte nach einem der Ansprüche 1 bis 6, **dadurch gekennzeichnet, dass** das Stanzgitter (6) und/oder das Bauteil (2) als SMD-Bauteil ausgebildet sind und die Strompfade (5) des Stanzgitters (6) die Oberseite der Leiterplatte (1) kontaktieren.

## Claims

1. A printed circuit board comprising a three-dimensionally shaped lead frame (6) comprising a plurality of current paths (5) partially encapsulated by plastic (7), and at least one electric or electronic component (2), **characterized in that** the lead frame (6) is of angular shape, wherein free end faces of the current paths (5) of the lead frame (6) extending over the lead frame legs (4, 9) are in contact with the printed circuit board (1) and the component (2) is arranged in a defined orientation between the current paths (5).

2. Printed circuit board according to claim 1, **characterized in that** at least one of the legs (9) of the lead frame (6) has an enlarged surface in comparison to the other leg (4).

3. Printed circuit board according to claim 1 or 2, **characterized in that** the component (2) in contact with the current paths (5) is a sensor, in particular a Hall sensor, or a means of lighting.

4. Printed circuit board according to claim 3, **characterized in that** a reflector (10) arranged on the lead frame (6) is allocated to the means of lighting configured as a light-emitting diode (3).

5. Printed circuit board according to claim 3, **characterized in that** a fibre optic light guide is allocated to the means of lighting configured as a light-emitting diode (3).

6. Printed circuit board according to one of the claims 3 to 5, **characterized in that** the leg (4) of the lead frame (6), provided with the means of lighting configured as a light-emitting diode (3), is aligned in parallel to a light emission surface of a diffuser disk of a light unit, in particular an interior light of a motor vehicle.

7. Printed circuit board according to one of the claims 1 to 6, **characterized in that** the lead frame (6) and/or the component (2) are constructed as a SMD component and the current paths (5) of the lead frame (6) are in contact with the upper side of the printed circuit board (1).

## Revendications

1. Carte à circuits imprimés comprenant un grillage estampé (6) mis sous forme tridimensionnelle, qui comprend plusieurs trajets électriques (5) partiellement enrobés de matière plastique (7) et au moins un composant (2) électrique ou électronique,
**caractérisée en ce que** le grillage estampé (6) est réalisé en forme d'équerre, de sorte que des côtés frontaux libres des trajets électriques (5) du grillage estampé qui s'étendent sur les branches (4, 9) viennent en contact avec la carte à circuits imprimés (1), et **en ce que** le composant (2) est agencé entre les trajets électriques (5) dans une orientation définie.

2. Carte à circuits imprimés selon la revendication 1, **caractérisée en ce que** l'une au moins des branches (9) du grillage estampé (6) présente une surface agrandie par rapport à l'autre branche (4).

3. Carte à circuits imprimés selon la revendication 1 ou 2,
**caractérisée en ce que** le composant (2) qui vient en contact avec les trajets électriques (5) est un capteur, en particulier un capteur de Hall, ou un élément d'éclairage.

4. Carte à circuits imprimés selon la revendication 3, **caractérisée en ce que**, à l'élément d'éclairage réalisé sous forme de diode électroluminescente (3) est associé un réflecteur (10) agencé sur le grillage estampé (6).

5. Carte à circuits imprimés selon la revendication 3, **caractérisée en ce que**, à l'élément d'éclairage réalisé sous forme de diode électroluminescente (3) est associé un guide d'ondes.

6. Carte à circuits imprimés selon l'une des revendications 3 a 5, **caractérisée en ce que** la branche (4) du grillage estampé (6) équipée de l'élément d'éclairage réalisé sous forme de diode électroluminescente (3) est orientée parallèlement à une surface de sortie de lumière d'une plaque de diffusion (8) d'une lampe, en particulier d'une lampe intérieure d'un véhicule automobile.

7. Carte à circuits imprimés selon l'une des revendications 1 à 6, **caractérisée en ce que** le grillage estampé (6) et/ou le composant (2) sont réalisés sous forme de composants montés en surface ("SMD"), et les trajets électriques (5) du grillage estampé (6) viennent en contact avec la face supérieure de la carte à circuits imprimés (1).
